**Europäisches Patentamt**

**European Patent Office**

**Office européen des brevets**

(11) Veröffentlichungsnummer: **0 046 914**
**B1**

(12) # EUROPÄISCHE PATENTSCHRIFT

(45) Veröffentlichungstag der Patentschrift:
03.07.85

(21) Anmeldenummer: **81106341.1**

(22) Anmeldetag: **14.08.81**

(51) Int. Cl.⁴: **H 01 L 21/24,** H 01 L 21/60,
H 01 L 21/268

(54) Verfahren zum Herstellen von legierten Metallkontaktschichten auf kristallorientierten Halbleiteroberflächen mittels Energiepulsbestrahlung.

(30) Priorität: **28.08.80 DE 3032461**
**04.12.80 DE 3045784**

(43) Veröffentlichungstag der Anmeldung:
**10.03.82 Patentblatt 82/10**

(45) Bekanntmachung des Hinweises auf die Patenterteilung:
**03.07.85 Patentblatt 85/27**

(84) Benannte Vertragsstaaten:
**CH FR GB IT LI SE**

(56) Entgegenhaltungen:
**EP - A - 0 019 186**
**DD - A - 123 408**
**DD - A - 140 942**
**US - A - 4 151 008**

(73) Patentinhaber: **Siemens Aktiengesellschaft, Berlin und München Wittelsbacherplatz 2, D-8000 München 2 (DE)**

(72) Erfinder: **Patalong, Hubert, Dr., Kurt-Flöricke-Strasse 18, D-8000 München 60 (DE)**
Erfinder: **Krimmel, Eberhard, F. Dr., Mendelssohnstrasse 7, D-8023 Pullach (DE)**

**Beschreibung**

Die vorliegende Patentanmeldung betrifft ein Verfahren zur Herstellung von legierten Metallkontaktschichten auf kristallorientierten Halbleiteroberflächen durch Aufbringen einer Metallschicht auf einen Bereich der Halbleiteroberfläche und anschliessendem Einlegieren der Metallschicht in die Halbleiteroberfläche mittels ganzflächiger Bestrahlung der Metallschicht mit einem Energiepuls.

Ein solches Verfahren ist aus der deutschen Patentschrift 2 825 212 bekannt. Bei diesem Verfahren werden extrem dünne Metallschichten, welche durch Aufdampfen, Zerstäuben, elektrolytische Abscheidung oder Ionendeposition auf einem Halbleitersubstrat aufgebracht worden sind, mit einem intensiven kurzen Laserlichtpuls bestrahlt und dabei an die Halbleiteroberfläche anlegiert. Dabei müssen die Bestrahlungsbedingungen so gewählt werden, dass in dem Substrat keine nennenswerte Diffusion stattfindet. Die Pulsdauer der Laserlichtpulse liegt deshalb im Nanosekundenbereich. Das bekannte Verfahren ist auf die Herstellung extrem dünner Metallstrukturen, wie sie beispielsweise in der VLSI-Technologie Anwendung finden, beschränkt.

In der Halbleitertechnologie wählt man im allgemeinen die Oberflächen, zum Beispiel für Siliziummaterial, aus dem Bauelemente hergestellt werden sollen, in der Ebene einer bestimmten bevorzugten Kristallorientierung.

Beispielsweise werden die Thyristoren der Zukunft mit Hilfe integrierter Feldeffekttransistoren erzeugte, steuerbare Kurzschlüsse enthalten. Daher wird es notwendig sein, die Leistungshalbleiter- und die MOS-Technik miteinander zu kombinieren. Während in der Leistungshalbleitertechnik wegen der guten Legierbarkeit $\langle 111 \rangle$-orientiertes Silizium verwendet wird, wird in der MOS-Technik vorzugsweise $\langle 100 \rangle$-orientiertes Silizium als Ausgangsmaterial verarbeitet, weil hier andere Kristalleigenschaften erheblich schwerer ins Gewicht fallen.

Ein weiterer wesentlicher Gesichtspunkt ist, dass sich $\langle 100 \rangle$-Silizium-Grundmaterial leichter ziehen und homogener dotieren lässt als $\langle 111 \rangle$-Silizium. $\langle 100 \rangle$-Silizium ist deshalb erheblich wirtschaftlicher herstellbar. Die Verwendung des $\langle 100 \rangle$-Siliziums wäre deshalb auch vorteilhafter für die Herstellung von Leistungshalbleiterbauelementen.

Der Einsatz von $\langle 100 \rangle$-orientiertem Silizium zur Herstellung von Thyristoren stösst jedoch bei der Legierung zwischen Metallschichten und Silizium auf Schwierigkeiten. Die Aluminium-Silizium-Legierung erfolgt in $\langle 100 \rangle$-orientiertem Silizium-Oberflächen sehr ungleichmässig, so dass die negative Sperrfähigkeit sehr mangelhaft ist.

Die Aufgabe, die der Erfindung zugrundeliegt, besteht deshalb darin, die Legierungsfreudigkeit einer dünnen Oberflächenschicht der $\langle 100 \rangle$-orientierten Siliziumkristallscheibe gegenüber dem Kontaktmetall zu erhöhen, damit die gesamte Fläche gleich zu Beginn des Legierungsvorganges anlegiert und dadurch eine gleichmässig dicke Legierungsschicht erreicht wird.

Diese Aufgabe wird erfindungsgemäss dadurch gelöst, dass vor dem Aufbringen der Metallschicht der für den Metallkontakt vorgesehene Bereich der Halbleiteroberfläche mit einer dichten Folge intensiver und scharf fokussierter Laserlichtpulse durch dichtes Nebeneinandersetzen von Einzelstrahlbündelquerschnitten abgerastert wird, so dass kleine Verdampfungskrater entstehen.

Dabei liegt es im Rahmen der Erfindung, dass als Halbleiteroberfläche eine in $\langle 100 \rangle$-Richtung orientierte Siliziumkristalloberfläche und als Kontaktmetall zum Beispiel Aluminium, welches vorzugsweise in Form einer Folie aufgepresst wird, verwendet wird. Es ist aber auch möglich, als Kontaktmaterialschicht eine aus mindestens einem Metallsilizid bestehende Schicht aufzubringen. Vorzugsweise werden dabei die Silizide von Molybdän, Wolfram, Titan, Tantal, Niob, Platin oder Palladium verwendet und durch Aufdampfen oder Aufsputtern aus einem, das Metallsilizid enthaltenden Target oder aus zwei, jeweils eine Komponente enthaltenden Quellen auf die in $\langle 100 \rangle$-Richtung orientierte, vorher mit dem intensiven Laserlichtpuls abgerasterte Siliziumoberfläche aufgebracht. Das anschliessende Einlegieren kann durch einen Hochtemperatur-Ofenprozess oder ebenfalls durch Laserpulsbestrahlung, beispielsweise mit einem Dauerstrichlaser oder durch ganzflächiges Bestrahlen mit einem Rubinpulslaser (20 nsec) erfolgen. Dabei wird die Leistung in Abhängigkeit von der Schichtdicke eingestellt.

Gemäss einem besonders günstigen Ausführungsbeispiel nach der Lehre der Erfindung wird zur Laserlichtpulsabrasterung ein Nd:YAG-Pulslaser mit einer Wellenlänge von 1,06 μm, einer Pulsdauer von 0,5 μs und einer Leistung im Bereich von 50 Watt verwendet, das Lichtstrahlenbündel des Lasers auf einen Durchmesser von 50 μm fokussiert und die zu behandelnde Halbleiteroberfläche mit einer Pulsfrequenz von 4 kHz durch dichtes Nebeneinandersetzen der Einzelstrahlenbündelquerschnitte abgerastert. Die gesamte Bestrahlungszeit für eine etwa 7,5 cm grosse $\langle 100 \rangle$-orientierte Siliziumkristallscheibe beträgt für dieses Beispiel ca. 1 Minute.

Das Verfahren nach der Lehre der Erfindung lässt sich folgendermassen erklären:
Wird eine Siliziumoberfläche mit einem kurzen Laser-Lichtpuls oberhalb einer kritischen Intensität $I_{kr}$ bestrahlt, so verdampft von der bestrahlten Oberflächenstelle etwas Silizium. Dadurch entsteht ein kleiner Krater vom Durchmesser des Laserstrahlbündels. Beim Abkühlen dieser Stelle bildet sich insbesondere an den Kraterrändern eine mit vielen Versetzungslinien durchwachsene polykristalline Oberflächenschicht. Wird die kritische Intensität $I_{kr}$ nicht allzusehr überschritten, bleibt das Versetzungsliniennetzwerk auf die Oberflächenschicht begrenzt.

Das dichte Versetzungsliniennetzwerk und die verschiedenen Orientierungen der Kristallite der polykristallinen Oberflächenschicht begünstigen das Anlösen des Silizium durch das Aluminium und das auch bei ⟨100⟩-orientierten Siliziumscheiben, so dass sich eine gleichmässig dünne Oberflächen-Aluminium-Silizium-Legierungsschicht ausbildet.

Elektronenstrahlbeugungsdiagramme in Reflexion zeigen von der unbestrahlten, geläppten Scheibenrückseite das Kikuchi-Diagramm einer perfekten einkristallinen Oberflächenschicht. Nach dem Laserbestrahlen an Luft werden diffuse Debye-Scherrer-Ringe sichtbar, die auf eine dünne, nicht notwendigerweise stöchiometrische Oxidschicht hinweisen. Diese Oxidschicht ist ca. 30 nm dick. Nach dem Abätzen mit Flusssäure erscheinen einzelne Bragg-Reflexe überlagert mit einem Debye-Scherrer-Ringsystem, das von polykristallinen Oberflächenbereichen stammt. Die Kraterböden dürften einkristallin sein, während die Kraterränder polykristalline Struktur besitzen. Demnach ist das Verfahren um so wirkungsvoller, je feiner das Laserlichtstrahlenbündel fokussiert ist und je dichter die einzelnen Bestrahlungsflekke liegen.

Im Gegensatz zu dem in der deutschen Patentschrift 2 825 212 beschriebenen Verfahren zum Anlegieren extrem dünner Strukturen ist das erfindungsgemässe Verfahren insbesondere zum Herstellen dickerer Legierungsschichten geeignet.

Durch die Verwendung der Metallsilizidschicht als Kontaktmaterialschicht an Halbleiterbauelementen wird der ohm'sche Widerstand gegenüber zum Beispiel hochdotierten polykristallinen Siliziumschichten um den Faktor 5 bis 10 vermindert. Weitere Vorteile ergeben sich aufgrund der Ätzungseigenschaften (guter Ätzstop) der Silizide bei der Herstellung der Bauelemente und einer hohen Stabilität bei Temperaturbelastung.

Im folgenden sollen anhand von Ausführungsbeispielen und der Figuren 1 bis 8 die einzelnen Verfahrensschritte schematisch dargestellt und noch kurz erläutert werden. Dabei gelten in den Figuren für gleiche Teile die gleichen Bezugszeichen.

Die Figuren 1 bis 4 betreffen ein Ausführungsbeispiel, bei dem eine Aluminiumschicht als Kontaktmaterial verwendet wird,

die Figuren 5 und 6 sind ein Ausführungsbeispiel mit einer Molybdänsilizidschicht (MoSi₂),

die Figuren 7 und 8 zeigen die durch das erfindungsgemässe Verfahren erreichte Verbesserung der elektrischen Parameter.

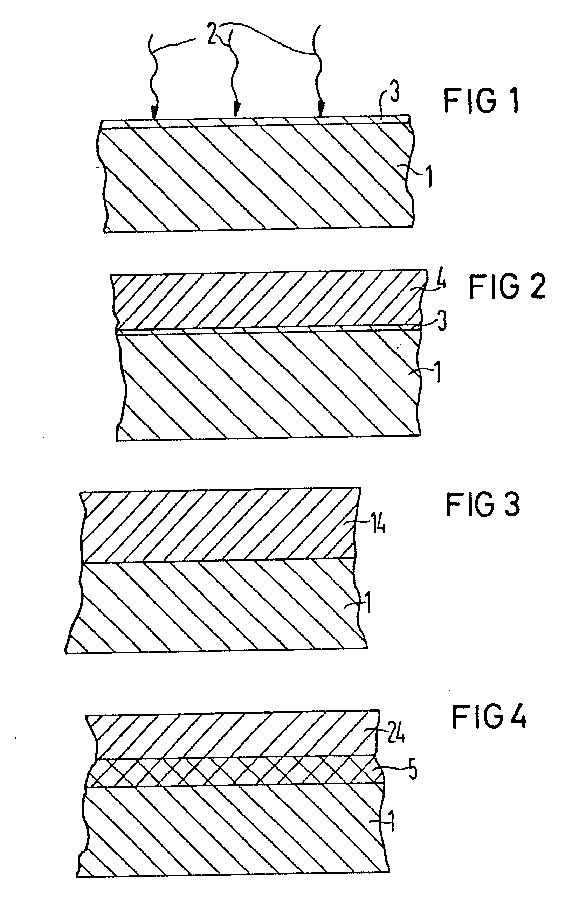

Eine Siliziumkristallscheibe 1 mit einer in ⟨100⟩-Richtung orientierten Oberfläche wird, wie in Figur 1 dargestellt, mit scharf fokussierten, intensiven Laserlichtpulsen 2 abrasternd bestrahlt, so dass Verdampfungskrater mit einer dünnen Oberflächenschicht 3 aus ausgedehnten Versetzungsliniennetzwerken und Polykristallen entstehen, die der nachfolgenden Legierung keinen Widerstand mehr entgegensetzen.

Auf diese gestörte Oberflächenschicht 3 wird, wie aus Figur 2 zu entnehmen ist, eine Aluminium-Schicht 4 durch Aufdampfen, Zerstäuben, elektrolytische Abscheidung oder durch Anpressen einer Folie aufgebracht und in den Halbleiterkörper 1 einlegiert. Dabei bildet sich zunächst auf der Siliziumkristallscheibe 1 eine Aluminium-Silizium-Schmelze 14 (siehe Figur 3), welche bei der Abkühlung in ein Aluminium-Silizium-Eutektikum 24 und eine p-leitende Siliziumschicht 5 übergeht (siehe Figur 4).

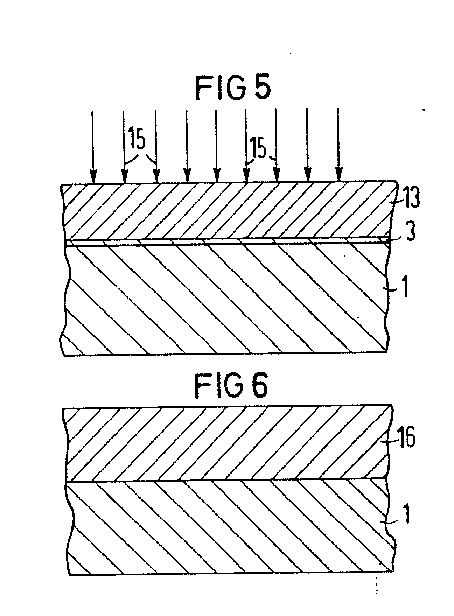

Figur 5: Auf die gestörte Oberflächenschicht 3 (siehe Figur 1) wird, wie aus Figur 5 zu entnehmen ist, eine Molybdänsilizidschicht 13 (MoSi₂) durch Aufsputtern aufgebracht und in die Siliziumkristallscheibe 1 einlegiert. Dies kann beispielsweise auch durch Laserbestrahlen, zum Beispiel durch ganzflächiges Bestrahlen durch einen Pulslaser (siehe Pfeile 15) erfolgen, wobei die Leistung des Lasers in Abhängigkeit von der Schichtdicke der Molybdän-Silizidschicht eingestellt wird. Bei einer Schichtdicke von einigen zehn bis einigen hundert Nanometer liegen die eingestrahlten Energiedichten bei Pulsbestrahlung im Bereich von etwa $1-5\,J \cdot cm^{-2}$ ($J = $ Joule). Dabei bilden sich auf der Siliziumoberfläche 1 nach der Bestrahlung ein Molybdän-Silizium-Eutektikum 16 oder verschiedene koexistierende Phasen von Siliziden aus, welche die in ⟨100⟩-Richtung orientierte Siliziumoberfläche 1 gleichmässig benetzen (siehe Figur 6).

Nach der Durchführung des Verfahrens nach der Lehre der Erfindung wurden in bezug auf die elektrischen Parameter folgende Ergebnisse erzielt:

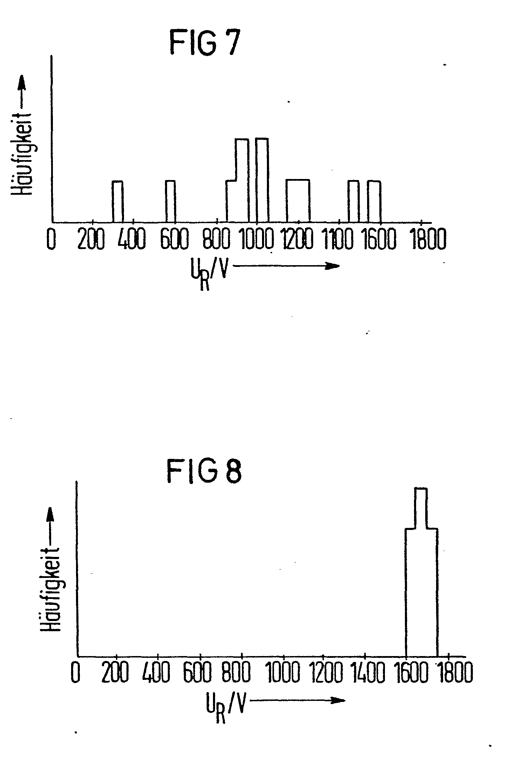

Es wurden Thyristoren, welche mittels integrierter Feldeffekttransistoren erzeugte steuerbare Kurzschlüsse enthalten, aus ⟨100⟩-Silizium hergestellt. Ein Teil der ⟨100⟩-orientierten Silizium-Scheiben wurden vor der Legierung der erfindungsgemässen Laserbehandlung unterzogen. Die Häufigkeit der gemessenen Sperrfähigkeit $U_R$/V in negativer Richtung ist aus den Figuren 7 und 8 ersichtlich. Die Sperrfähigkeit ist bei den unbehandelten Scheiben (siehe Figur 7), wie auch in früheren Versuchen schon festgestellt wurde, schlecht. Bei den laserbehandelten Scheiben (siehe Figur 8) dagegen ist die negative Sperrfähigkeit grundlegend verbessert und erreicht die Sperrfähigkeit von Thyristoren aus ⟨111⟩-orientierten Silizium. Damit ist gezeigt, dass auch ⟨100⟩-orientiertes Silizium mit Aluminium legierbar ist, wenn die zu legierende Fläche vorher eine dementsprechende Laserbehandlung erfährt. An den Laser selbst werden dabei keine besonderen Güteanforderungen gestellt.

Durch das Verfahren nach der Lehre der Erfindung ist die Möglichkeit gegeben, die MOS-Technologie und die Bipolar-Technologie besser zu integrieren.

**Patentansprüche**

1. Verfahren zur Herstellung von legierten Metallkontaktschichten auf kristallorientierten Halbleiteroberflächen durch Aufbringen einer Metallschicht auf einen Bereich der Halbleiteroberfläche und anschliessendem Einlegieren der Metallschicht in die Halbleiteroberfläche mittels ganzflächiger Bestrahlung der Metallschicht mit einem Energiepuls, dadurch gekennzeichnet, dass vor dem Aufbringen der Metallschicht (4, 13) der für den Metallkontakt vorgesehene Bereich der Halbleiteroberfläche mit einer dichten Folge intensiver und scharf fokussierter Laserlichtpulse (2) durch dichtes Nebeneinandersetzen von Einzelstrahlbündelquerschnitten abgerastert wird, so dass kleine Verdampfungskrater entstehen.

2. Verfahren nach Anspruch 1, dadurch gekennzeichnet, dass als Halbleiteroberfläche eine in $\langle 100\rangle$-Richtung orientierte Siliziumkristalloberfläche und als Kontaktmetall Aluminium verwendet wird.

3. Verfahren nach Anspruch 2, dadurch gekennzeichnet, dass das Aluminium in Form einer Folie aufgepresst wird.

4. Verfahren nach Anspruch 1, dadurch gekennzeichnet, dass als Halbleiteroberfläche eine in $\langle 100\rangle$-Richtung orientierte Siliziumkristalloberfläche und als Kontaktmaterialschicht eine aus mindestens einem Metallsilizid bestehende Schicht aufgebracht wird.

5. Verfahren nach Anspruch 4, dadurch gekennzeichnet, dass Silizide von Molybdän, Wolfram, Titan, Tantal, Niob, Platin oder Palladium verwendet werden.

6. Verfahren nach Anspruch 4 und 5, dadurch gekennzeichnet, dass die Metallsilizide durch Aufdampfen oder durch Aufsputtern aus einem, das Metallsilizid enthaltenden Target oder aus zwei, jeweils eine Komponente enthaltenden Quelle aufgebracht wird.

7. Verfahren nach den Ansprüchen 4 bis 6, dadurch gekennzeichnet, dass das Einlegieren durch Laserbestrahlen oder Elektronenbestrahlen durchgeführt wird.

8. Verfahren nach Anspruch 7, dadurch gekennzeichnet, dass das Einlegieren durch ganzflächiges Bestrahlen durch einen Pulslaser vorgenommen wird, wobei die Leistung in Abhängigkeit von der Schichtdicke eingestellt wird.

9. Verfahren nach den Ansprüchen 1 bis 8, dadurch gekennzeichnet, dass zur Laserlichtpulsabrasterung ein Nd:YAG-Pulslaser mit einer Wellenlänge von 1,06 µm, einer Pulsdauer von 0,5 µs und einer Leistung im Bereich von 50 W verwendet wird.

10. Verfahren nach Anspruch 9, dadurch gekennzeichnet, dass das Lichtstrahlenbündel des Lasers auf einen Durchmesser von 50 µm fokussiert und die zu behandelnde Halbleiteroberfläche mit einer Pulsfrequenz von 4 kHz abgerastert wird.

11. Verfahren nach den Ansprüchen 1 bis 10, dadurch gekennzeichnet, dass die gesamte Bestrahlungszeit für eine etwa 7,5 cm grosse $\langle 100\rangle$-orientierte Siliziumkristallscheibe auf ca. 1 Minute eingestellt wird.

## Claims

1. A method of forming alloyed metal contact layers on crystallographically-oriented semiconductor surfaces by applying a metal layer to a region of the semiconductor surface and subsequently alloying the metal layer into the semiconductor surface by means of total-area irradiation of the metal layer with an energy pulse, characterized in that, prior to the application of the metal layer (4, 13), the region of the semiconductor surface which is intended for the metal contact is scanned by means of a dense series of intensive and clearly focussed laser light pulses (2) by closely placing beside one another, cross-sectional areas of individual beam bundles, so that small evaporation craters are formed.

2. A method as claimed in Claim 1, characterised in that a silicon crystal surface which is oriented in the $\langle 100\rangle$-direction is used as semiconductor surface, and aluminium is used as contact metal.

3. A method as claimed in Claim 2, characterised in that the aluminium is pressed on in the form of a foil.

4. A method as claimed in Claim 1, characterised in that a silicon crystal surface which is oriented in the $\langle 100\rangle$-direction, is applied as semiconductor surface and a layer consisting of at least one metal silicide, is applied as contact metal layer.

5. A method as claimed in Claim 4, characterised in that silicides of molybdenum, tungsten, titanium, tantalum, niobium, platinum, or palladium, are used.

6. A method as claimed in Claim 4 and Claim 5, characterised in that the metal silicides are applied by vapour deposition, or by sputtering from a target which contains the metal silicide, or from two sources each containing a respective component.

7. A method as claimed in Claim 4 to 6, characterised in that the alloying is carried out by laser irradiation or electron irradiation.

8. A method as claimed in Claim 7, characterised in that the alloying is carried out by total-area irradiating by means of a pulsed laser, the power being regulated in dependence upon the layer thickness.

9. A method as claimed in Claim 1 to 8, characterised in that an Nd:YAG pulsed laser having a wavelength of 1.06 µm, a pulse duration of 0.5 µs and a power in the region of 50 W is used for the laser light pulse scanning.

10. A method as claimed in Claim 9, characterised in that the light beam of the laser is focussed to a diameter of 50 µm and the semiconductor surface which is to be treated is scanned at a pulse frequency of 4 kHz.

11. A method as claimed in Claim 1 to 10, characterised in that the overall irradiation time for a $\langle 100\rangle$-oriented silicon crystal disc which has a size of approximately 7.5 cm is set at about 1 minute.

## Revendications

1. Procédé de fabrication de couches métalliques de contact alliées sur des surfaces semiconductrices à orientation cristalline, par dépôt d'une couche métallique sur une région de la surface semiconductrice et ensuite par incorporation par alliage de la couche métallique dans la surface semiconductrice, en exposant, sur toute la surface, la couche métallique à un rayonnement énergétique pulsé, caractérisé en ce qu'il consiste, avant le dépôt de la couche métallique (4, 13), à balayer la région de la surface semiconductrice, qui est prévue pour le contact métallique, avec une succession rapprochée d'impulsions lumineuses laser (2) intenses et focalisées d'une manière fine en mettant étroitement les unes à côté des autres des sections transversales de faysceaux individuels de rayonnement, de manière à créer de petits cratères d'évaporation.

2. Procédé suivant la revendication 1, caractérisé en ce qu'il consiste à utiliser, comme surface semiconductrice, une surface de cristal de silicium orientée dans la direction ⟨100⟩ et, comme métal de contact, de l'aluminium.

3. Procédé suivant la revendication 2, caractérisé en ce qu'il consiste à appliquer l'aluminium par pression sous la forme d'une feuille.

4. Procédé suivant la revendication 1, caractérisé en ce qu'il consiste à déposer, comme surface semiconductrice, une surface de cristal de silicium orientée suivant la direction ⟨100⟩ et, comme couche de matériau de contact, une couche constituée d'au moins un siliciure métallique.

5. Procédé suivant la revendication 4, caractérisé en ce qu'il consiste à utiliser des siliciures de molybdène, de tungstène, de titane, de tantale, de niobium, de platine ou de palladium.

6. Procédé suivant les revendications 4 et 5, caractérisé en ce qu'il consiste à déposer les siliciures métalliques par dépôt en phase vapeur ou par pulvérisation cathodique, à partir d'une cible contenant du siliciure métallique, ou de deux sources contenant respectivement un constituant.

7. Procédé suivant les revendications 4 à 6, caractérisé en ce qu'il consiste à effectuer l'incorporation par alliage par exposition à un rayonnement laser ou par exposition à un rayonnement électronique.

8. Procédé suivant la revendication 7, caractérisé en ce qu'il consiste à effectuer l'incorporation par exposition sur toute la surface à un laser pulsé, la puissance étant réglée en fonction de l'épaisseur de la couche.

9. Procédé suivant les revendications 1 à 8, caractérisé en ce qu'il consiste à utiliser, pour le balayage par des impulsions de lumière laser, un laser à impulsions Nd:YAG ayant une longueur d'onde de 1,06 micron, une durée d'impulsion de 0,5 µs et une puissance de l'ordre de 50 W.

10. Procédé suivant la revendication 9, caractérisé en ce qu'il consiste à focaliser le faisceau de rayonnement lumineux du laser à un diamètre de 50 microns, et à balayer la surface semiconductrice à traiter avec une fréquence d'impulsions de 4 kHz.

11. Procédé suivant les revendications 1 à 10, caractérisé en ce qu'il consiste à régler la durée totale d'exposition à une minute environ, pour une plaquette de cristal de silicium à orientation ⟨100⟩ de 7,5 cm environ.

FIG 1

FIG 2

FIG 3

FIG 4

## FIG 5

13
3
1

## FIG 6

16
1

# FIG 7

# FIG 8